# EUROPÄISCHE PATENTSCHRIFT

(11) **EP 1 299 908 B1**
(45) Veröffentlichungstag und Bekanntmachung des Hinweises auf die Patenterteilung: **11.09.2013**
(21) Anmeldenummer: 01984193.1
(22) Anmeldetag: 06.07.2001
(51) Int. Cl.: H01L 25/075, H01L 33/00, F21V 19/00, G09F 9/33

(54) **VERFAHREN ZUR HERSTELLUNG EINER LED-LICHTQUELLE**
METHOD FOR PRODUCING A LED LIGHT SOURCE
PROCEDE DE PRODUCTION D'UNE SOURCE LUMINEUSE DE DIODE ELECTROLUMINESCENTE

(30) Priorität: 12.07.2000 AT 12052000
(43) Veröffentlichungstag der Anmeldung: 09.04.2003
(60) Teilanmeldung: 10184279.7
(73) Patentinhaber: Tridonic Jennersdorf GmbH, 8380 Jennersdorf (AT)
(72) Erfinder: TASCH, Stefan, A-8380 Jennersdorf (AT); PACHLER, Peter, A-8010 Graz (AT); WILCZEK, Klaus, Peter, 83404 Ainring (DE); HOCHFILZER, Christian, A-8010 Graz (AT)
(74) Vertreter: Rupp, Christian
(86) Internationale Anmeldenummer: PCT/AT2001/000223
(87) Internationale Veröffentlichungsnummer: WO 2002/005350

(56) Entgegenhaltungen:
- EP-A- 0 588 040
- EP-A- 0 864 432
- EP-A- 0 986 103
- WO-A-01/47039
- DE-C- 19 854 899
- GB-A- 2 276 032
- US-A- 5 936 353
- PATENT ABSTRACTS OF JAPAN vol. 1995, no. 03, 28. April 1995 (1995-04-28) -& JP 06 349892 A (MATSUSHITA ELECTRIC), 22. Dezember 1994 (1994-12-22)
- PATENT ABSTRACTS OF JAPAN vol. 1996, no. 02, 29. Februar 1996 (1996-02-29) -& JP 07 263754 A (NICHIA CHEM IND), 13. Oktober 1995 (1995-10-13)
- PATENT ABSTRACTS OF JAPAN vol. 1996, no. 10, 31. Oktober 1996 (1996-10-31) -& JP 08 148723 A (MATSUSHITA ELECTRIC), 7. Juni 1996 (1996-06-07)
- PATENT ABSTRACTS OF JAPAN vol. 1999, no. 11, 30. September 1999 (1999-09-30) & JP 11 161197 A (MATSUSHITA ELECTRIC), 18. Juni 1999 (1999-06-18)
- PATENT ABSTRACTS OF JAPAN vol. 2000, no. 02, 29. Februar 2000 (2000-02-29) & JP 11 320962 A (CANON INC), 24. November 1999 (1999-11-24)
- HATADA K ET AL: "LED array modules by new technology microbump bonding method" TRANS. ON COMPONENTS, HYBRIDS, AND MANUFACTURING TECHNOL, 1990, Bd. 13, Seiten 521-527, XP000149633 ISSN: 0148-6411
- IMLER W: "Presision flip-chip solder bump interconnects for moptical packaging" TRANS. COMPONENTS, HYBRIDS, AND MANUFACTURING TECHNOL, 1992, Bd. 15, Seiten 977-981, XP000364759 ISSN: 0148-6411
- HALL J ET AL: "Packaging of VCSEL, MC-LED, and detector 2D-arrays" IEEE ECTC, SEATTLE, 1998, Seiten 778-782, XP000803663 ISBN: 0-7803-4527-4

## Beschreibung

### TECHNISCHES GEBIET

Die vorliegende Erfindung betrifft ein Verfahren zur Herstellung einer LED-Lichtquelle hoher Lichtstärke mit mindestens zwei LED-Dice, wobei die LEDs auf einer thermisch leitfähigen Leiterplatte angeordnet werden, sodass im Betrieb die Wärme durch die Leiterplatte hindurch abgeleitet wird.

### STAND DER TECHNIK

Aus der US-5936353-A ist bereits bekannt, LEDs mit hoher Dichte auf einer Leiterplatte aus Keramik oder Metall anzuordnen. Dies hat den Vorteil, dass im Betrieb die Wärme durch die Leiterplatte hindurch abgeführt werden kann. Es ist so möglich, auf der Rückseite einen Kühlkörper aufzusetzen. Geeignete Materialien sind BeO, Al₂O₃, Kupfer oder Aluminium oder AlN.

Zweck dieser Maßnahme ist natürlich, eine möglichst hohe Leuchtdichte zu erhalten, und dazu ist auch eine Optimierung der Befestigung und elektrischen Kontaktierung notwendig, wie im Folgenden ausgeführt wird.

LEDs verarbeitet auf Lead-Frames basierend auf Die- und Wirebonding-Prozessen und neuerdings mit Flip-Chip Technik sind Stand der Technik.

Die derzeit effizientesten blauen und grünen LEDs basieren auf GaN auf Saphir-Substraten. Aufgrund des nichtleitenden Substrates bei diesem Aufbau sind beide Kontakte an der Oberseite des LED-Die angeordnet. Die Lichtemission, welche innerhalb der GaN-Schicht des LED-Dice entsteht, wird durch die Kontaktflächen jedoch erheblich eingeschränkt. Derart kann die externe Leistungsausbeute dieser LED-Dice bis zu einem. Faktor 2 gesteigert werden, wenn diese mit den Kontaktflächen nach unten mittels einer Flip-Chip Technologie verarbeitet werden (für Flip Chip Technologien siehe z.B. US-5438477-A, US-5111279-A). Ähnliche Vorteile können bei roten und orangen Dice, welche auf transparenten Substraten basieren, erzielt werden, sofern diese face down bzw. mit einer Seitenfläche gebondet werden, so dass die Emission durch die gegenüberliegende Fläche erfolgt. Die elektrische Kontaktierung erfolgt in letzterem Fall über die Stirnflächen.

Dieser wesentliche Vorteil der Flip-Chip Technologie zur Verarbeitung der LED-Dice im Hinblick auf die Erzeugung von hoher Helligkeit auf geringem Raum kann noch gesteigert werden, wenn LEDs in Array-Form mittels Flip-Chip Technologie direkt auf die Leiterplatte aufgebracht werden.

Ein besonders wichtiger Aspekt bei dieser Anordnung ist das Thermomanagement. Die Kontaktflächen zwischen dem Die und den Kontaktpads der Leiterplatte sind geringer im Vergleich zu einer konventionellen Die/Wire Bonding Technologie. Aus diesem Grund ist die thermische Leitfähigkeit des Verbindungsmaterials zwischen LED-Die und Leiterplatte noch essentieller als bei der konventionellen Chip-On-Board Technologie.

Außerdem werden an die Strukturierung der Leiterbahnen hohe Anforderungen gestellt. Die maximale Strukturierungsbreite liegt im Bereich von 50-100 µm. Da typischerweise aufgrund technologischer Limitationen die maximale Strukturbreite mit der Schichtdicke der Leiterbahnen korreliert, darf diese ebenfalls maximal diese Werte annehmen. Im Hinblick auf eine gute thermische Ableitung ist eine gute Wärmeabführung der Leiterbahnen, die durch die Art der Leiterbahn und deren Schichtdicke bestimmt ist, essentiell. Zusätzliche Wärmeableitung vom Die auf die Leiterplatine kann durch den Einsatz einer thermisch leitfähigen Vergussmaße, die zwischen Die und Leiterplatte eingebracht wird (Underfill), erreicht werden.

Weiters sind besondere Vorkehrungen zu treffen, dass bei der Kontaktierung der Dice kein Kurzschluss zwischen den beiden Kontaktstellen entsteht.

### OFFENBARUNG DER ERFINDUNG

Es ist Aufgabe der vorliegenden Erfindung, das Verfahren der eingangs genannten Art zu verbessern, um LED-Arrays mit möglichst hoher Helligkeit bei möglichst geringer Baugröße zu realisieren.

Diese Aufgabe wird durch ein Verfahren der eingangs genannten Art erfindungsgemäß dadurch gelöst, dass das Verfahren folgende Schritte beinhaltet:
- die Leiterplatte wird - mit Ausnahme der Kontaktflächen - mittels einer isolierenden Schicht versehen,
- entweder werden auf den Kontaktelektroden der LED-Dice auf einer Fläche Kontaktbumps oder Kontaktschichten mit einer Maximalhöhe von 100 µm bestehend aus einem Lotmaterial mit guter thermischer Leitfähigkeit aufgebracht, oder es werden Kontaktschichten mit einer Dicke von 1-50 µm auf den Kontaktflächen der Leiterplatte aufgebracht,
- die LED Dice werden mittels einer Flip-Chip Technik oder einer verwandten Technik mit der Kontaktfläche nach unten auf die Kontaktflächen der Leiterplatte oder in deren unmittelbare Nähe aufgepresst und gleichzeitig oder anschließend - mittels Ultraschalls oder thermisch - verlötet.

Es werden also auf den Leiterbahnen Kontaktflächen hergestellt, dazwischen befindet sich eine isolierende Schicht. Der LED-Dice wird anschließend auf diese Flächen aufgepresst und befestigt. Derart kann ein Kurzschluss zwischen den positiven und negativen Kontaktzonen verhindert werden. Durch die angegebenen Abmessungen ist eine ausreichende Wärmeabfuhr gewährleistet.

Dieses Verfahren kann dahingehend abgewandelt werden, dass nicht gelötet wird, sondern dass metallische, insbesondere aus Gold bestehenden Kontaktbumps oder Kontaktschichten verwendet werden und dass die LED-Dice exakt auf die freien Kontaktflächen der Leiterplatte aufgepresst und mittels eines Thermocompressionsverfahrens befestigt werden.

Bei LEDs mit Kontakten auf den Stirnflächen beinhaltet das Verfahren folgende Schritte:
- die Leiterplatte wird - mit Ausnahme der Kontaktflächen - mittels einer isolierenden Schicht versehen,
- auf den Kontaktelektroden der LED-Dice werden auf einer Fläche Kontaktbumps oder Kontaktschichten mit einer Maximalhöhe von 100 µm bestehend aus einem Lotmaterial mit guter thermischer Leitfähigkeit aufgebracht,
- die LED-Dice werden mit den Kontaktflächen senkrecht zur Leiterplattenebene mit einer Seitenfläche auf die freien Kontaktflächen der Leiterplatte oder in deren unmittelbare Nähe aufgepresst und mit den seitlich aufgebrachten Kontaktbumps verlötet, wobei jedem LED-Die eine Mindestmetallisierungsfläche zwischen 0,5 und 5 mm² zugeordnet ist.

Zur Erzielung einer hohen Leuchtdichte ist es zweckmäßig, wenn mehr als 4 Dice, teilweise seriell und teilweise parallel geschaltet, aufgepresst werden.

Zur Luftkühlung kann auf der Rückseite der Leiterplatte ein Kühlkörper aufgebracht werden, z.B. angeklebt werden. Man wird diesen meist so dimensionieren, dass dessen maximale Temperatur bei Dauerbetrieb um höchstens 45°C über der Umgebungstemperatur liegt.

Zum Ankleben des Kühlkörpers kann eine dünne, beidseitig beschichtete Klebematte verwendet werden, es kann aber auch eine beidseitig beschichtete Kupferfolie zum Ankleben des Kühlkörpers verwendet werden.

Anstatt den Kühlkörper anzukleben, kann er an die Rückseite der Leiterbahn flächig angelötet werden. Zum Anlöten des Kühlkörpers kann ein Vakuum-Lötofen verwendet werden.

Anstatt einer Luftkühlung kann auf der Rückseite der Leiterplatte eine elektrische Kühlung aufgebracht werden.

Es ist für Leuchtdichte und Thermomanagement zweckmäßig, wenn LED-Dice mit einer Grundfläche zwischen 300 und 700 µm² aufgepresst werden.

Die thermisch leitfähige Leiterplatte kann zumindest eine keramische Schicht beinhalten, oder man kann als Leiterplatte eine Metallkernleiterplatte verwenden.

Gemäß einer anderen Ausführungsform kann als Leiterplatte ein Keramikkörper verwendet werden, auf dessen Oberseite die Leiterbahnen aufgebracht sind und dessen Oberfläche derart ausgeformt ist, dass dieser als Kühlkörper dient. Auf diese Weise braucht kein zusätzlicher Kühlkörper mit der Leiterplatte verbunden werden.

Schließlich ist es zweckmäßig, wenn die Kontaktflächen auf der Leiterbahn oval oder rechteckig sind und eine Länge aufweisen, die annähernd der Kantenlänge des LED-Die entspricht. Auf diese Weise ergeben sich möglichst große Kontaktstellen, was für die elektrische, aber besonders für die thermische Leitfähigkeit wichtig ist.

### BESTE AUSFÜHRUNGSFORM DER ERFINDUNG

Anhand eines Beispiels wird die vorliegende Erfindung näher erläutert. Man verwendet eine Keramikleiterplatte (bestehend aus Al₂O₃, AIN, BN, BeO,..), die mit Metallen, wie Cu, Ag/Pd, Au beschichtet ist. Hierbei werden bevorzugt Dickschichtkeramikleiterplatten, also Keramikleiterplatten, bei denen die Leiterbahnen mittels einer Siebdrucktechnik aufgebracht sind, eingesetzt. Weiters können Leiterplatten mit galvanisch abgeschiedenen Metallisierungen oder mittels Dünnschichttechnik aufgebrachten Metallisierungen eingesetzt werden. Die Strukturierung der Leiterplatte erfolgt mittels photolithographischer Techniken bzw. bei Dickschichtsystemen direkt beim Aufdruck.

Auf die Leiterbahnen wird eine isolierende Schicht aufgebracht, die sich nicht durchgehend über die Oberfläche der Leiterplatte erstreckt, sondern Ausnehmungen über den Kontaktzonen aufweist. In einer bevorzugten Variante sind diese Ausnehmungen derart ausgeführt, dass diese rechteckige oder ovale Form aufweisen, um eine möglichst große Fläche auf der Kontaktseite des LED-Die zu kontaktieren.

Es werden dann Kontaktbumps (bestehend aus Lotmaterialien, NiAu, Au oder ähnlichem) auf den LED-Die aufgebracht. Diese können beispielsweise mittels einer Laserschweißtechnik oder mittels Wire Bonding Prozessen. aufgebracht werden und aus einem niedrigschmelzenden Lötmaterial oder Au bestehen. Kontakte, die über derartige Bumps ausgeführt sind, weisen allerdings den Nachteil auf, dass der Abstand von den Kontaktflächen des Die relativ zur Leiterplatte durch die Bumphöhe (> 50 µm) vorgegeben wird, wodurch eine gute Wärmeableitung vom Die zur Leiterplatte behindert wird. Alternativ zu den Bumps werden Kontaktschichten auf die Leiterplatten aufgebracht, die als Kontakte dienen. Die Schichtdicken dieser Schichten werden im Bereich von 5-50 µm gewählt.

Anschließend werden die Dice auf der Leiterplatte mittels einer Pick- and Place Apparatur platziert. Dann erfolgt ein gezieltes Aufheizen und anschließendes Abkühlen der aufgesetzten Dice, so dass das Lot oder Au schmilzt und dann erstarrt, wodurch die Dice auf der Leiterplatte fixiert werden. Alternativ zum Löten wird zum Befestigen des LED-Dice auf der Leiterplatte ein Thermocompressionsverfahren eingesetzt. Die LED-Dice werden derart aufgesetzt bzw. die Metallisierung ist in einer Art strukturiert, dass jedem LED-Die eine Mindestmetallisierungsfläche zwischen 0,5 und 5 mm² zugeordnet ist.

Um Entladungen über den LED-Die beim Aufsetzen zu verhindern, kann optional aus ESD-Gründen eine Diode antiparallel zu den LED aufgesetzt werden.

Es ist natürlich möglich, dass zumindest ein LED-Die eine andere Emissionsfarbe als die anderen aufweist und dessen Betriebsstrom unabhängig von dem Betriebsstrom der anderen geregelt werden kann, sodass Mischfarben erzeugt werden können.

## Patentansprüche

1. Verfahren zur Herstellung einer LED-Lichtquelle hoher Lichtstärke mit mindestens zwei LED-Dice, wobei die LEDs auf einer thermisch leitfähigen Leiterplatte angeordnet werden, sodass im Betrieb die Wärme durch die Leiterplatte hindurch abgeleitet wird, **dadurch gekennzeichnet, dass** das Verfahren folgende Schritte beinhaltet:
- die Leiterplatte wird - mit Ausnahme der Kontaktflächen
- mit einer isolierenden Schicht versehen,
- entweder werden auf den Kontaktelektroden der LED-Dice auf einer Fläche Kontaktbumps oder Kontaktschichten mit einer Maximalhöhe von 100 µm bestehend aus einem Lotmaterial mit guter thermischer Leitfähigkeit aufgebracht, oder es werden Kontaktschichten mit einer Dicke von 1-50 µm auf den Kontaktflächen der Leiterplatte aufgebracht,
- die LED Dice werden dann mittels einer Flip-Chip Technik oder einer verwandten Technik mit der Kontaktfläche nach unten auf die Kontaktflächen der Leiterplatte oder in deren unmittelbare Nähe aufgepresst und gleichzeitig oder anschließend - mittels Ultraschall und/oder thermisch - verlötet.

2. Verfahren zur Herstellung einer LED-Lichtquelle hoher Lichtstärke mit mindestens zwei LED-Dice, wobei die LEDs auf einer thermisch leitfähigen Leiterplatte angeordnet werden, sodass im Betrieb die Wärme durch die Leiterplatte hindurch abgeleitet wird, **dadurch gekennzeichnet, dass** das Verfahren folgende Schritte beinhaltet:
- die Leiterplatte wird - mit Ausnahme der Kontaktflächen
- mit einer isolierenden Schicht versehen,
- entweder werden auf den Kontaktelektroden der LED-Dice
- entweder werden auf den Kontaktelektroden der LED-Dice auf einer Fläche metallische, insbesondere aus Gold bestehende Kontaktbumps oder Kontaktschichten mit einer Maximalhöhe von 100 µm aufgebracht, oder es werden metallische, insbesondere aus Gold bestehende Kontaktschichten mit einer Dicke von 1-50 µm auf den Kontaktflächen der Leiterplatte aufgebracht,
- die LED-Dice werden dann mittels einer Flip-Chip Technik oder einer verwandten Technik mit der Kontaktfläche nach unten exakt auf die Kontaktflächen der Leiterplatte aufgepresst und gleichzeitig oder anschließend - mittels Ultraschall und/oder thermisch - befestigt.

3. Verfahren zur Herstellung einer LED-Lichtquelle hoher Lichtstärke mit mindestens zwei LED-Dice, wobei die LEDs auf einer thermisch leitfähigen Leiterplatte angeordnet werden, sodass im Betrieb die Wärme durch die Leiterplatte hindurch abgeleitet wird, **dadurch gekennzeichnet, dass** das Verfahren folgende Schritte beinhaltet:
- die Leiterplatte wird - mit Ausnahme der Kontaktflächen
- mit einer isolierenden Schicht versehen,
- auf den Kontaktelektroden der LED-Dice werden auf einer Fläche Kontaktbumps oder Kontaktschichten mit einer Maximalhöhe von 100 µm bestehend aus einem Lotmaterial mit guter thermischer Leitfähigkeit aufgebracht,
- die LED-Dice werden dann mit den Kontaktflächen senkrecht zur Leiterplattenebene mit einer Seitenfläche auf die freien Kontaktflächen der Leiterplatte oder in deren unmittelbare Nähe aufgepresst und mit den seitlich aufgebrachten Kontaktbumps verlötet.

4. Verfahren nach einem der Ansprüche 1-3, **dadurch gekennzeichnet, dass** eine thermisch leitfähige Vergussmaße zwischen Die und Leiterplatte gegeben wird.

5. Verfahren nach einem der Ansprüche 1 bis 4, **dadurch gekennzeichnet, dass** mehr als 4 Dice, teilweise seriell und teilweise parallel geschaltet, aufgepresst werden.

6. Verfahren nach einem der Ansprüche 1 bis 5, **dadurch gekennzeichnet, dass** auf der Rückseite der Leiterplatte ein Kühlkörper zur Luftkühlung aufgebracht wird.

7. Verfahren nach Anspruch 6, **dadurch gekennzeichnet, dass** der Kühlkörper an die Leiterplatte angeklebt wird.

8. Verfahren nach Anspruch 7, **dadurch gekennzeichnet, dass** eine dünne, beidseitig beschichtete Klebematte zum Ankleben des Kühlkörpers verwendet wird.

9. Verfahren nach Anspruch 7, **dadurch gekennzeichnet, dass** eine beidseitig beschichtete Kupferfolie zum Ankleben des Kühlkörpers verwendet wird.

10. Verfahren nach einem der Ansprüche 1 bis 6, **dadurch gekennzeichnet, dass** der Kühlkörper an die Rückseite der Leiterbahn flächig angelötet wird.

11. Verfahren nach Anspruch 10, **dadurch gekennzeichnet, dass** zum Löten Anlöten des Kühlkörpers ein Vakuum-Lötofen verwendet wird.

12. Verfahren nach einem der Ansprüche 1 bis 5, **dadurch gekennzeichnet, dass** auf der Rückseite der Leiterplatte eine elektrische Kühlung aufgebracht wird.

13. Verfahren nach einem der Ansprüche 1 bis 12, **dadurch gekennzeichnet, dass** LED-Dice mit einer Grundfläche zwischen 300 und 700 µm² aufgepresst werden.

14. Verfahren nach einem der Ansprüche 1 bis 13, **dadurch gekennzeichnet, dass** die thermisch leitfähige Leiterplatte zumindest eine keramische Schicht beinhaltet.

15. Verfahren nach einem der Ansprüche 1 bis 13, **dadurch gekennzeichnet, dass** als Leiterplatte eine Metallkernleiterplatte verwendet wird.

16. Verfahren nach einem der Ansprüche 1-6, **dadurch gekennzeichnet, dass** als Leiterplatte ein Keramikkörper verwendet wird, auf dessen Oberseite die Leiterbahnen aufgebracht sind und dessen Oberfläche derart ausgeformt ist, dass dieser als Kühlkörper dient.

17. Verfahren nach einem der Ansprüche 1 bis 16, **dadurch gekennzeichnet, dass** die Kontaktflächen auf der Leiterbahn oval oder rechteckig sind und eine Länge aufweisen, die annähernd der Kantenlänge des LED-Die entspricht.

## Claims

1. Method for producing an LED light source with a high luminous intensity comprising at least two LED dice, the LEDs being arranged on a thermally conductive printed circuit board, with the result that the heat is dissipated through the printed circuit board during operation, **characterized in that** the method includes the following steps:
- the printed circuit board is, with the exception of the contact faces,
- provided with an insulating layer,
- either contact bumps or contact layers with a maximum height of 100 µm consisting of a solder material with good thermal conductivity are applied to the contact electrodes of the LED dice on one face, or contact layers with a thickness of 1 - 50 µm are applied to the contact faces of the printed circuit board,
- the LED dice are then pressed onto the contact faces of the printed circuit board or in the direct vicinity thereof with the contact face down by means of flip-chip technology or a related technology and at the same time or subsequently soldered, by means of ultrasound and/or thermally.

2. Method for producing an LED light source with a high luminous intensity comprising at least two LED dice, the LEDs being arranged on a thermally conductive printed circuit board, with the result that the heat is dissipated through the printed circuit board during operation, **characterized in that** the method includes the following steps:
- the printed circuit board is, with the exception of the contact faces,
- provided with an insulating layer,
- either metal, in particular gold, contact bumps or contact layers with a maximum height of 100 µm are applied to the contact electrodes of the LED dice on one face, or metal, in particular gold, contact layers with a thickness of 1 - 50 µm are applied to the contact faces of the printed circuit board,
- the LED dice are then pressed precisely onto the contact faces of the printed circuit board with the contact face down by means of flip-chip technology or a related technology and at the same time or subsequently fixed, by means of ultrasound and/or thermally.

3. Method for producing an LED light source with a high luminous intensity comprising at least two LED dice, the LEDs being arranged on a thermally conductive printed circuit board, with the result that the heat is dissipated through the printed circuit board during operation, **characterized in that** the method includes the following steps:
- the printed circuit board is, with the exception of the contact faces,
- provided with an insulating layer,
- contact bumps or contact layers with a maximum height of 100 µm consisting of a solder material with good thermal conductivity are applied to the contact electrodes of the LED dice on one face,
- the LED dice are then pressed with one side face, with the contact faces perpendicular to the printed circuit board plane, onto the free contact faces of the printed circuit board or in the direct vicinity thereof and soldered to the laterally applied contact bumps.

4. Method according to one of Claims 1-3, **characterized in that** a thermally conductive casting compound is provided between the die and the printed circuit board.

5. Method according to one of Claims 1 to 4, **characterized in that** more than four dice, sometimes connected in series and sometimes connected in parallel, are pressed on.

6. Method according to one of Claims 1 to 5, **characterized in that** a heat sink for air cooling is applied to the rear side of the printed circuit board.

7. Method according to Claim 6, **characterized in that** the heat sink is adhesively bonded to the printed circuit board.

8. Method according to Claim 7, **characterized in that** a thin adhesive mat coated on both sides is used for adhesively bonding the heat sink.

9. Method according to Claim 7, **characterized in that** a copper film coated on both sides is used for adhesively bonding the heat sink.

10. Method according to one of Claims 1 to 6, **characterized in that** the heat sink is soldered areally to the rear side of the printed circuit board.

11. Method according to Claim 10, **characterized in that**, in order to solder the heat sink, a vacuum soldering furnace is used.

12. Method according to one of Claims 1 to 5, **characterized in that** electrical cooling is applied to the rear side of the printed circuit board.

13. Method according to one of Claims 1 to 12, **characterized in that** LED dice with a base area of between 300 and 700 µm² are pressed on.

14. Method according to one of Claims 1 to 13, **characterized in that** the thermally conductive printed circuit board contains at least one ceramic layer.

15. Method according to one of Claims 1 to 13, **characterized in that** a metal-core printed circuit board is used as printed circuit board.

16. Method according to one of Claims 1-6, **characterized in that** a ceramic body is used as printed circuit board, with the conductor tracks being applied to the upper side of said ceramic body and the surface thereof being shaped in such a way that it acts as heat sink.

17. Method according to one of Claims 1 to 16, **characterized in that** the contact faces on the printed circuit board are oval or rectangular and have a length which corresponds to approximately the edge length of the LED die.

## Revendications

1. Procédé pour la fabrication d'une source de lumière à LED à haute intensité lumineuse avec au moins deux puces à LED, les LEDs étant disposées sur un circuit imprimé thermiquement conducteur, de telle sorte qu'en fonctionnement la chaleur est évacuée à travers le circuit imprimé, **caractérisé en ce que** le procédé comprend les étapes suivantes :
- le circuit imprimé est - à l'exception des surfaces de contact - pourvu d'une couche isolante,
- soit des bosses de contact ou des couches de contact avec une hauteur maximale de 100 µm consistant en un matériau de soudage ayant une bonne conductivité thermique sont montées sur les électrodes de contact des puces à LED sur une surface, soit des couches de contact avec une épaisseur de 1-50 µm sont montées sur les surfaces de contact du circuit imprimé,
- les puces à LED sont ensuite engagées par pression sur les surfaces de contact du circuit imprimé ou à proximité immédiate de celui-ci avec la surface de contact vers le bas au moyen d'une technique à puce retournée ou d'une technique apparentée, et sont soudées - au moyen d'ultrasons et/ou thermiquement - simultanément ou ultérieurement.

2. Procédé pour la fabrication d'une source de lumière à LED à haute intensité lumineuse avec au moins deux puces à LED, les LEDs étant disposées sur un circuit imprimé thermiquement conducteur, de telle sorte qu'en fonctionnement la chaleur est évacuée à travers le circuit imprimé, **caractérisé en ce que** le procédé comprend les étapes suivantes :
- le circuit imprimé est - à l'exception des surfaces de contact - pourvu d'une couche isolante,
- soit des bosses de contact métalliques, en particulier constituées d'or, ou des couches de contact avec une hauteur maximale de 100 µm sont montées sur les électrodes de contact des puces à LED sur une surface, soit des couches de contact métalliques, en particulier constituées d'or, avec une épaisseur de 1-50 µm sont montées sur les surfaces de contact du circuit imprimé,
- les puces à LED sont ensuite engagées par pression exactement sur les surfaces de contact du circuit imprimé avec la surface de contact vers le bas au moyen d'une technique à puce retournée ou d'une technique apparentée, et sont fixées - au moyen d'ultrasons et/ou thermiquement - simultanément ou ultérieurement.

3. Procédé pour la fabrication d'une source de lumière à LED à haute intensité lumineuse avec au moins deux puces à LED, les LEDs étant disposées sur un circuit imprimé thermiquement conducteur, de telle sorte qu'en fonctionnement la chaleur est évacuée à travers le circuit imprimé, **caractérisé en ce que** le procédé comprend les étapes suivantes :
- le circuit imprimé est - à l'exception des surfaces de contact - pourvu d'une couche isolante,
- des bosses de contact ou des couches de contact avec une hauteur maximale de 100 µm consistant en un matériau de soudage ayant une bonne conductivité thermique sont montées sur les électrodes de contact des puces à LED sur une surface,
- les puces à LED sont ensuite engagées par pression avec une surface latérale, avec les surfaces de contact perpendiculaires à la surface du circuit imprimé, sur les surfaces de contact libres du circuit imprimé ou à proximité immédiate de celui-ci, et sont soudées avec les bosses de contact montées latéralement.

4. Procédé selon l'une des revendications 1 à 3, **caractérisé en ce qu'**une masse de scellement thermiquement conductrice est mise entre la/les puce(s) et le circuit imprimé.

5. Procédé selon l'une des revendications 1 à 4, **caractérisé en ce que** plus de 4 puces, montées partiellement en série et partiellement en parallèle, sont engagées par pression.

6. Procédé selon l'une des revendications 1 à 5, **caractérisé en ce qu'**un dissipateur de chaleur destiné à un refroidissement à air est monté sur le dos du circuit imprimé.

7. Procédé selon la revendication 6, **caractérisé en ce que** le dissipateur de chaleur est collé sur le circuit imprimé.

8. Procédé selon la revendication 7, **caractérisé en ce qu'**un tapis adhésif recouvert sur chaque côté et fin est utilisé pour coller le dissipateur de chaleur.

9. Procédé selon la revendication 7, **caractérisé en ce qu'**un film de cuivre recouvert sur chaque côté est utilisé pour coller le dissipateur de chaleur.

10. Procédé selon l'une des revendications 1 à 6, **caractérisé en ce que** le dissipateur de chaleur est soudé sur une grande étendue au dos du circuit imprimé.

11. Procédé selon la revendication 10, **caractérisé en ce qu'**un four à braser à vide est utilisé pour souder le dissipateur de chaleur.

12. Procédé selon l'une des revendications 1 à 5, **caractérisé en ce qu'**un refroidissement électrique est monté au dos du circuit imprimé.

13. Procédé selon l'une des revendications 1 à 12, **caractérisé en ce que** des puces à LED ayant une surface de base comprise entre 300 et 700 µm² sont engagées par pression.

14. Procédé selon l'une des revendications 1 à 13, **caractérisé en ce que** le circuit imprimé thermiquement conducteur comprend au moins une couche en céramique.

15. Procédé selon l'une des revendications 1 à 13, **caractérisé en ce qu'**un circuit imprimé à noyau métallique est utilisé comme circuit imprimé.

16. Procédé selon l'une des revendications 1 à 6, **caractérisé en ce qu'**un corps en céramique est utilisé comme circuit imprimé, des pistes conductrices étant montées sur sa surface supérieure et sa surface supérieure étant formée de telle sorte que celui-ci sert de dissipateur de chaleur.

17. Procédé selon l'une des revendications 1 à 16, **caractérisé en ce que** les surfaces de contact sur la piste conductrice sont ovales ou rectangulaires et présentent une longueur qui correspond approximativement à la longueur d'arête de la puce à LED.
